# EUROPÄISCHE PATENTSCHRIFT

(11) **EP 0 723 389 B1**
(45) Veröffentlichungstag und Bekanntmachung des Hinweises auf die Patenterteilung: **02.04.2003**
(21) Anmeldenummer: 96100705.1
(22) Anmeldetag: 18.01.1996
(51) Int. Cl.: H05K 7/00, H05K 9/00, H01R 13/00

(54) **Anschlussvorrichtung für Standard-Flachbaugruppen**
Connecting device for standard flat assemblies
Dispositif de connexion pour les modules plats standardisés

(30) Priorität: 19.01.1995 DE 29500815 U
(43) Veröffentlichungstag der Anmeldung: 24.07.1996
(73) Patentinhaber: Fujitsu Siemens Computers GmbH, 81739 München (DE)
(72) Erfinder: Zenkner, Heinz, Dipl.-Ing., D-86156 Augsburg (DE); Stöbrich, Werner, D-86485 Biberach (DE); Neukam, Wilhelm, Dipl.-Ing., D-86159 Augsburg (DE)
(74) Vertreter: Epping, Wilhelm, Dipl.-Ing.

(56) Entgegenhaltungen:
- DE-A- 3 243 132
- DE-C- 4 110 800
- US-A- 4 779 744
- US-A- 4 995 820

## Beschreibung

Die Erfindung betrifft eine Anschlußvorrichtung gemäß den Merkmalen des Oberbegriffs des Anspruchs 1.

Standard-Flachbaugruppen, insbesondere in der Computertechnik, werden üblicherweise mit Hilfe von Montagewinkeln an entsprechend gestalteten Einbauplätzen montiert. Diese Einbauplatze bestehen aus einer im wesentlichen rechteckigen schlitzförmigen Aussparung in einer Gehäusewandung mit seitlichen Schraubanschlüssen, an denen der Montagewinkel lösbar befestigt werden kann. Bei derartigen Einbauplätzen erfolgt der Masse- bzw. Ground-Anschluß über die "Versorgungsschiene" bzw. über die am Montagewinkel befestigten Steckeranschlüsse. Dieser Massekontakt reicht zwar für die elementare Funktion der Baugruppe aus, nicht jedoch in bezug auf die aus EMV-Gründen notwendige hochfrequente Abschirmung.

Der vorliegenden Erfindung liegt deshalb die Aufgabe zugrunde, für eine Anschlußvorrichtung der im Oberbegriff des Anspruchs 1 angegebenen Art eine hochfrequenzdichte Abschirmung zu gewährleisten, die den EMV-Vorschriften in vollem Umfang gerecht wird.

Die Lösung dieser Aufgabe ergibt sich erfindungsgemäß durch die Merkmale des Anspruchs 1. Vorteilhafte Weiterbildungen der Erfindung sind in Unteransprüchen angegeben.

Im folgenden wird ein Ausführungsbeispiel der Erfindung anhand der Zeichnung naher erläutert. Dabei zeigen
Figur 1 eine Anschlußvorrichtung für Standard-Flachbaugruppen ohne Abschirmvorrichtung,
Figur 2 eine erfindungsgemäß ausgebildete Kontaktfeder für eine Vorrichtung gemäß Figur 1,
Figur 3 eine erfindungsgemäß ausgebildete Anschlußvorrichtung im perspektivischer Explosionsdarstellung.

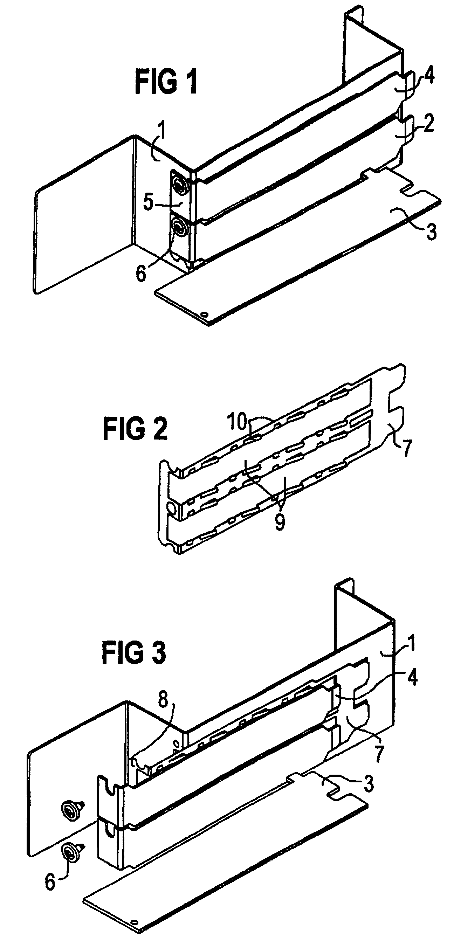

Die Figur 1 zeigt einen Ausschnitt aus einem Rechnergehäuse mit zwei an einer rechteckigen Einbuchtung einer Gehäusewandung 1 parallel zueinander angeordneten Einbauplätzen, an denen, jeweils eine schlitzartige Aussparung in der Gehäusewandung abdeckend, ein Montagewinkel 2 mit zugehöriger Flachbaugruppe 3 und darüber ein Blindwinkel 4 ohne Baugruppe befestigt sind. Zur Befestigung sind am Montagewinkel 2 und am Blindwinkel rechtwinklig angesetzte Halteschenkel vorgesehen, die sich am ebenfalls abgewinkelten Teil der Gehäusewandung 1 anschmiegen und dort mittels Schrauben 6 lösbar befestigt werden.

Der Montagewinkel 2 bzw. der Blindwinkel 4 decken zwar die dahinter vorgesehenen Aussparungen in der Gehäusewandung, rein optisch gesehen, ausreichend ab, dennoch verbleiben aufgrund von Fertigungstoleranzen und Materialverspannungen am Gehäuse und/oder am Anschlußwinkel mehr oder weniger große Schlitze, die in bezug auf die hochfrequenzdichte Abschirmung (EMV) des Gehäuses erhebliche Probleme bereiten können. Um den Erfordernissen einer hochfrequenzdichten Abschirmung ausreichend gerecht zu werden, ist eine in der Figur 2 dargestellte Kontaktfeder 7 vorgesehen, die zwischen Gehäusewandung 1 und Montagewinkel 2 bzw. Blindwinkel 4 federnd eingespannt wird. Diese Kontaktfeder 7 hat die Form eines längsgestreckten Rahmens mit angeformtem Haltewinkel 8 und mit einer der Gehäuseaussparung angepaßten schlitzartigen Aussparung 9. An den Innenkanten des Rahmens sind mehrere Federelemente 10 in Form herausgestanzter Federzungen vorgesehen, die im Wechsel an der Vorder- und Rückseite vorspringen. Diese Federelemente 10 stützen sich im montierten Zustand der Kontaktfeder 7 sowohl am Montagewinkel 2 bzw. Blindwinkel 4 als auch an der Gehäusewandung 1 federnd ab.

Die perspektivische Explosionsdarstellung in Figur 3 zeigt die Lage der Kontaktfeder 7 zwischen Gehäusewandung 1 und Montagewinkel 2 bzw. Blindwinkel 4. Die Kontaktfeder 7 wird zweckmäßig in einer Vielzahl von Exemplaren aus einem fortlaufenden Metallband gefertigt, wobei je nach der Zahl der aufeinanderfolgenden Einbauplätze ein zusammenhängender, entsprechend viele Kontaktfedern enthaltender Federblock abtrennbar ist. Im dargestellten Beispiel mit zwei Einbauplätzen besteht dieser Federblock, wie aus Figur 2 ersichtlich, aus zwei Kontaktfedern.

## Patentansprüche

1. Anschlußvorrichtung für Standard-Flachbaugruppen mit Montagewinkel, die an parallel zueinander angeordneten Einbauplätzen in Form jeweils schlitzartiger Durchbrechungen einer Gehäusewandung lösbar befestigt werden, **gekennzeichnet durch** eine rahmenartige, zwischen Gehäusewandung und Montagewinkel eingespannte Kontaktfeder (7), die eine der schlitzartigen Durchbrechung entsprechende Aussparung (9) und mehrere längs des Federrahmens angeordnete Federelemente (10) aufweist.

2. Anschlußvorrichtung nach Anspruch 1,
**dadurch gekennzeichnet, daß** die Federelemente (10) als aus der rahmenförmigen Kontaktfeder (7)herausgerissene Federzungen ausgebildet sind.

3. Anschlußvorrichtung nach Anspruch 1 oder 2,
**dadurch gekennzeichnet, daß** die Federelemente (10) wechselseitig auf beiden Seiten der Kontaktfeder angeordnet sind.

4. Anschlußvorrichtung nach Anspruch 1 oder 2,
**dadurch gekennzeichnet, daß** die Federelemente (10) entlang der Innenkante des Kontaktfederrahmens angeordnet sind.

5. Anschlußvorrichtung nach einem der vorhergehenden Ansprüche,
**gekennzeichnet durch** ein aus mehreren parallel zueinander angeordneten Kontaktfedern (7) bestehendes Metallband, aus dem je nach der Zahl der Einbauplätze eine entsprechend viele Kontaktfedern enthaltender Federblock abtrennbar ist.

## Claims

1. Connecting device for standard flat assemblies with a mounting angle, which can be detachably fastened at mounting locations arranged parallel to each other in the form of respectively slot-like openings in a housing wall, **characterized by** a frame-like contact spring (7), which is clamped between the housing wall and the mounting angle and has a clearance (9) corresponding to the slot-like opening and a plurality of spring elements (10) arranged along the spring frame.

2. Connecting device according to Claim 1,
**characterized in that** the spring elements (10) are formed as spring tongues torn out from the frame-shaped contact spring (7).

3. Connecting device according to Claim 1 or 2,
**characterized in that** the spring elements (10) are arranged alternately on both sides of the contact spring.

4. Connecting device according to Claim 1 or 2,
**characterized in that** the spring elements (10) are arranged along the inner edge of the contact spring frame.

5. Connecting device according to one of the preceding claims, **characterized by** a metal strip which comprises a plurality of contact springs (7) arranged parallel to one another and from which, according to the number of mounting locations, a spring block containing a corresponding number of contact springs can be cut off.

## Revendications

1. Dispositif de connexion pour modules plats standardisés, comprenant une cornière de montage qui est fixée, de manière amovible, à des emplacements d'installation disposés parallèlement les uns au-dessus des autres sous la forme d'évidements latéraux en forme de fente, **caractérisé par** un ressort de contact (7), en forme de cadre, maintenu entre une paroi du boîtier et une cornière de montage, qui comporte une ouverture (9) correspondant à l'évidement latéral en forme de fente et plusieurs éléments de ressort (10) disposés le long du cadre de ressort.

2. Dispositif de connexion selon la revendication 1, **caractérisé en ce que** les éléments de ressort (10), ainsi que les ressorts de contact en forme de cadre, sont constitués de languettes élastiques estampées dans le ressort (7) de contact en forme de fente.

3. Dispositif de connexion selon la revendication 1 ou 2, **caractérisé en ce que** les éléments de ressort (10) sont disposés en alternance sur les deux côtés du ressort de contact.

4. Dispositif de connexion selon la revendication 1 ou 2, **caractérisé en ce que** les éléments de ressort (10) sont disposés le long du bord interne du cadre de ressort de contact.

5. Dispositif de connexion selon l'une des revendications précédentes, **caractérisé par** une bande métallique constituée de plusieurs ressorts de contact (7) disposés parallèlement les uns au-dessus des autres, et à partir de laquelle, selon le nombre d'emplacements d'installation, un bloc-ressort renfermant de nombreux ressorts de contact correspondants peut être séparé.
